(19) Europäisches Patentamt
European Patent Office
Office européen des brevets

(11) **EP 1 633 823 B1**

(12) **EUROPEAN PATENT SPECIFICATION**

(45) Date of publication and mention
of the grant of the patent:
**29.10.2008 Bulletin 2008/44**

(51) Int Cl.:
*C09D 11/00* (2006.01)     *C09D 11/10* (2006.01)
*C23F 1/02* (2006.01)     *G03F 7/004* (2006.01)

(21) Application number: **04734857.8**

(22) Date of filing: **26.05.2004**

(86) International application number:
**PCT/GB2004/002241**

(87) International publication number:
**WO 2004/106437 (09.12.2004 Gazette 2004/50)**

(54) **PROCESS FOR ETCHING A METAL OR ALLOY SURFACE**

VERFAHREN ZUM ÄTZEN EINER METALL- ODER METALLLEGIERUNG OBERFLÄCHE

PROCEDE POUR GRAVER UNE SURFACE METALLIQUE OU EN ALLIAGE

(84) Designated Contracting States:
**AT BE BG CH CY CZ DE DK EE ES FI FR GB GR HU IE IT LI LU MC NL PL PT RO SE SI SK TR**

(30) Priority: **30.05.2003 GB 0312925**
**11.10.2003 GB 0323870**

(43) Date of publication of application:
**15.03.2006 Bulletin 2006/11**

(73) Proprietor: **FUJIFILM Imaging Colorants Limited**
**Blackley,**
**Manchester**
**M9 8ZS (GB)**

(72) Inventors:
• **HOPPER, Alan John**
**Blackley,**
**Manchester M9 8ZS (GB)**
• **JAMES, Mark Robert**
**Blackley,**
**Manchester M9 8ZS (GB)**
• **CRUM, Simon Robert**
**Blackley,**
**Manchester M9 8ZS (GB)**

(74) Representative: **Mayall, John et al**
**Fujifilm Imaging Colorants Limited**
**Intellectual Property Group**
**P.O. Box 42**
**Hexagon Tower**
**Blackley, Manchester**
**M9 8ZS (GB)**

(56) References cited:
WO-A-95/23244       WO-A-20/04026977
WO-A-20/04028224     US-A- 4 270 985
US-A- 4 416 974      US-A- 5 270 368

**Description**

This invention relates to a process for etching a metal or alloy surface.

Etching of metals and alloys may be performed by a number of known methods. For example, mechanical etching is well known (e.g. drilling, stamping and cutting of metal and alloy surfaces) for the manufacture of decorative and industrial articles. Etching may be restricted to the surface as is often the case for artistic articles (for example jewellery) or it may involve total penetration as is often the case for industrial articles. The metal/alloy may be in the form of a sheet, foil or be part of an article. When in the form of a thin sheet or foil, the metal/alloy is often physically supported by a non-etchable substrate. The non-etchable substrate can optionally be removed from the metal or alloy.

More recently a process for etching metals and alloys known as photochemical machining ("PCM") has been developed. PCM is a complex process requiring the preparation of a photo-tool. Firstly, a metal or alloy surface is coated with a UV polymerisable etch-resist layer. A photo-tool is prepared which is a negative of the required etch image and is often a silver photographic emulsion plate. The photo-tool is placed directly over the etch-resist layer and is then exposed to UV light. This causes the etch-resist layer to polymerise and harden in those areas exposed to the UV light to produce a latent negative image of the required etch in the etch-resist layer. The etch-resist layer is then chemically treated to remove the unexposed, unpolymerised area of the etch-resist (this is known as the development step). When the etch-resist layer contains free acid groups a mildly alkaline treatment is used to remove the unexposed, unpolymerised areas. Exposed areas of the resultant metal or alloy are then etched using a chemical etching agent. Finally, the cured etch-resist layer may be removed chemically, for example using strong aqueous alkali, or it may be left in place.

Although PCM is widely used it has a number of deficiencies. PCM is a tedious and expensive process. PCM is wasteful of materials because the etch-resist layer is applied over the total area of the metal or alloy substrate even though masking is only required in certain areas of the substrate. Furthermore, the photo-tool containing the negative image of the desired etch pattern is often positioned some distance away from the etch-resist layer and diffraction of the UV light irradiation distorts the area of irradiation from what was intended. The diffraction of UV light irradiation needs to be taken into consideration when preparing the photo-tool because this reduces the density, accuracy and definition of etched features. Diffraction is especially problematic with finely etched features where the feature dimensions approach the wavelength of the UV light irradiation. This effect is known as a result of the Huygen's Principle.

In PCM, the chemical composition of the etch-resist ink needs to be very carefully controlled because it must adhere to the metal or alloy surface during the etching step and it must be made readily removable if desired. Typically the removal is carried out by chemical treatment after etching. A commonly used etch-resist removal method utilises alkali. The fine details in PCM etching can be seriously compromised if either the unexposed etch-resist is incompletely removed or if some of the exposed and polymerised etch-resist is removed prior to chemically etching the metal or alloy. The requirements for adhesion and removability pose a difficult balance in etch-resist ink chemistry.

Therefore, there exists a need for alternative etching methods which reduce or remove some of the above mentioned deficiencies of PCM.

According to the present invention there is provided a process for etching a metal or alloy surface as defined in claim 1.

Preferably the metal or alloy is not supported by a non-etchable substrate or where the metal or alloy is so supported the non-etchable substrate is removed after the etching process.

Preferably the etch-resistant ink is non-aqueous. This is preferred mainly because many of the preferred acrylate-functional monomers (component A) do not readily mix with water.

As mentioned above, the etch-resistant ink is substantially solvent-free. This is because solvents are not required in the inks, although traces of solvents may be present as minor impurities or by-products in the various components incorporated in the ink. Preferably the ink contains not greater than 2 parts, more preferably not greater than 1 part and especially not greater than 0.5 parts by weight of solvent, relative to the total weight of components A) to F). More preferably the etch-resistant ink is free from solvent.

The desired viscosity for the etch-resistant ink is largely dependent on the particular ink jet printhead employed and especially the temperature at which the printhead fires ink. At present most suitable commercial printheads operate at a temperature from 25°C to 100°C though the majority operate at a temperature from 25°C to 65°C. Consequently, it is preferred that the viscosity of the etch-resistant ink is not greater than 160cPs (mPa.s), more preferably not greater than 100 cPs (mPa.s) and especially not greater than 30cPs (mPa.s) at 40°C. Viscosity can be measured on any suitable equipment but is preferably measured using a Brookfield viscometer with a rotating spindle, for example a number 18 spindle. Preferably the viscosity is not greater than 20 and especially not greater than 15 cPs (mPa.s) at 40°C. It is also preferred that the viscosity is not less than 5 and especially not less than 8 cPs (mPa.s) at 40°C. Preferably the viscosity is from 8 to 15 cPs (mPa.s) at 40°C. Preferably the operating temperature of the print head is from 30 to 100°C, more preferably from 30 to 60°C and especially from 35 to 45°C.

Preferably the ink jet printing is carried out using a drop on demand (DOD) piezo ink jet printer.

The thickness of the ink jet printed etch-resistant ink applied to the metal or alloy surface can be varied widely according to the specific requirements of the metal or alloy and etchant used but from 5 to 50 microns thick is preferred. In some applications it is advantageous to vary the thickness over the metal or alloy surface. This can facilitate greater versatility and control in the etch step.

It is preferred that component A) comprises 5 to 95% by weight of one or more mono-functional monomers, relative to the total weight of component A. The remainder of Component A) (if any) has more than one acrylate group.

The term acrylate-functional as used hereinbefore means any monomer which contains the residue of a reactive vinyl group, for example $CH_2=C(R)CO-$ where R is hydrogen, alkyl or cyano. When R is alkyl it is preferably $C_{1-6}$- alkyl. It is particularly preferred that the acrylate functionality is conferred by a methacryloyl or especially an acryloyl group. The monomers may have a relatively low molecular weight or they may be oligomeric or polymeric in nature and may be of a molecular weight as high as 30,000. Acrylate-functional monomers are distinguished from component C) of the ink composition in that they have acrylate groups. These acrylate groups are unpolymerised and are reactive. Component A) may, however, be macromolecular and may contain hydrocarbyl groups linked by one or more heteroatoms as for example in polyethers, polyamides, urethanes, polyesters and ureas.

For clarity the acrylate-functional monomers (component A) have essentially no metal chelant group or groups (e.g. an acid group) since such a compound would be a metal adhesion promoting organic compound (component B) as defined hereinafter. It will be recognised that acrylate-functional monomers will sometime have a trace (e.g. less than 0.5% by weight) of the acid form of the acrylate as an impurity from the manufacturing process due, for example, to incomplete esterification:

The only limitation on the type and molecular size of the acrylate-functional monomers is that they should be compatible with each other, they should not form separate phases in the final etch-resistant ink and the etch-resistant ink must have the prescribed viscosity.

Typically, all of the acrylate-functional monomers of component A) have weight average molecular weights below 30,000, more preferably not greater than 10,000, even more preferably not greater than 5,000 and especially not greater than 2,000 because this helps keep the viscosity of the etch-resistant ink within the prescribed limits.

Specific examples of acrylate-functional monomers are those which are commercially available under the Sartomer™ Actilane™ and Photomer™ trademarks such as Sartomer™ 506 (isobornyl acrylate), Sartomer™ 306 (tripropylene glycol diacrylate), Actilane™ 430 (trimethylol propane ethoxylate triacrylate), Actilane™ 251 (a tri-functional urethane acrylate oligmer), Actilane™ 411 (a cyclic trimethylol propane formal mono-acrylate), Photomer™ 4072 (trimethylol propane propoxylate triacrylate) and Photomer™ 4039 (a phenol ethoxylate monoacrylate). Sartomer™, Actilane™ and Photomer™ are trademarks of Cray Valley Inc, Akros BV and Cognis Inc, respectively. Other examples of acrylate-functional monomers are lauryl acrylate, isodecylacrylate, isooctyl-acrylate, butyl acrylate, 2-hydroxy ethyl acrylate, 2-hydroxy propylacrylate, 2-ethyl hexyl acrylate, 1,6-hexanediol diacrylate, neopentyl glycol diacrylate, diethylene glycol diacrylate, butanediol diacrylate, trimethylolpropane triacrylate, pentaerythritol triacrylate, 1,3-butyleneglycol diacrylate, 1,4-butylene glycol diacrylate, triethylene glycol diacrylate, penta erythritol tetra acrylate, tripropylene glycol diacrylate, isobornyl acrylate, 2-norbornyl acrylate, cyclohexyl acrylate, phenoxyethyl acrylate and tetra hydrofurfuryl acrylate.

Preferably component A) comprises at least one monomer selected from isobornyl acrylate, tripropylene glycol diacrylate and trimethylol propane ethoxylate triacrytate.

Preferably component A) comprises an acrylate-functional urethane oligomer (e.g. Actilane™ 251).

Preferably the amount of component A) in the etch-resistant ink is from 40 to 90 parts, more preferably from 50 to 90 parts and especially from 60 to 90 parts by weight.

It is preferred that component A) comprises 15 to 95%, more preferably 40 to 95%, especially 60 to 95% and more especially 70 to 95% by weight of one or more mono-functional acrylate monomers, relative to the total weight of component A).

The metal adhesion promoting organic compound may be any organic compound which contains a metal chelant group or groups which can form a bond with the metal or alloy surface and which is compatible with component A). The metal or alloy often has a surface chemistry somewhat different from the bulk material. This can be due to atmospheric exposure or can be the result of a chemical or physical treatment process. Typical surface chemistries resulting from atmospheric exposure include oxides (e.g. iron, aluminium, zinc), hydrated oxides (e.g. $Fe_3O_4$. $xH_2O$) and carbonates (e.g. copper). Typical chemical surface treatments such as acid etching (e.g. HCl, $HNO_3$, $H_2SO_4$, $H_3PO_4$) and oxididizer etching (e.g. persulphates and perborates) can leave the metal or alloy surface in a variety of chemical forms. Typical physical treatments such as heating, plasma exposure and irradiation often result in oxide surfaces if performed in the presence of oxygen. For some inert metals and alloys the surface is almost identical to the bulk material (e.g. silver, gold and platinum). Irrespective of the exact surface chemistry, component B) is capable of forming a bond to a metal within the metal or alloy surface chemistry concerned. Component B) may be monomeric or polymeric in nature and may have one or more acrylate-functional groups as defined hereinbefore. Where component B) does not react with the acrylate-functional monomers of component A) it is preferably capable of intercalating with the polymeric material formed by component A) after exposure to actinic radiation and/or particle beam radiation (e.g. electron beam) and optionally thermal treatment. However, it is preferred that component B) is capable of reacting with the acrylate-functional monomers of component A) either during exposure to actinic radiation or particle beam radiation or during subsequent thermal treatment. Whilst component B) may contain any group capable of reacting with the acrylate-functional monomers of component A), it is very much preferred that component B) is also acrylate-functional and especially an acrylate-functional monomer, e.g. (meth)acrylic acid.

The metal chelant group of component B) is preferably any organic moiety which contains a hydrogen atom capable of being displaced by the metal of the metal or alloy surface or which possesses a lone pair of electrons capable of forming a bond with said metal. Examples of such groups are hydroxides, especially aryl or heteroaryl hydroxides (such as phenolic hydroxides); amines which may be aliphatic, aryl or heteroaryl; mercaptans which may be aliphatic, aryl or heteroaryl; oximes and ketoximines; acetarylamides; hydroxy silanes and silicones; N-containing heterocycles (such as imidazoles, benzimidazoles, triazoles, benztriazoles, thiazoles, isothiazoles); acid anhydrides, and acids (especially carboxylic acid, phosphonic acid, and sulphonic acid). Where component B) contains more than one metal chelant group these may be the same or different. In one preferred class of metal adhesion promoting organic compounds which contains two chelant groups, the chelant groups are attached to adjacent carbon atoms such as β-diketones. β-keto esters, β-keto aldehydes and β-keto heterocycles.

Less preferably the metal chelant groups are hydroxides, amines which may be aliphatic, aryl or heteroaryl; or mercaptans which may be aliphatic, aryl or heteroaryl.

More preferably the metal chelant groups are ketoximines; acetarylamides; hydroxy silanes and silicones; aryl or heteroaryl hydroxides (such as phenolic hydroxides); N-containing heterocycles (such as imidazoles, benzimidazoles, triazoles, benztriazoles, thiazoles, isothiazoles); acid anhydrides; β-diketones, β-keto esters, β-keto aldehydes, β-keto heterocycles; and acids (especially carboxylic acids, phosphonic acids and sulphonic acids).

Especially preferred metal chelant groups are β-diketones, β-keto esters, β-keto aldehydes, β-keto heterocycles and carboxylic acids.

More especially the metal chelant group is a carboxylic acid. Examples include 2-acrylamido glycolic acid, mono-2-(methacryloyloxy) ethyl phthalate, acrylic acid, methacrylic acid, 2-carboxyethyl acrylate, 2-acetamido acrylic acid, mono-2-(acryloyloxy) ethyl succinate, 2,2-bis(acryloylamino) acetic acid, bis-(3-sulphopropyl) itaconic acid, ethylene glycol methacrylate, itaconic acid, 2-(sulpho oxy) ethyl methacrylic acid, 2-acrylamido-2-methyl-1-propane sulphonic acid, 3-sulphopropyl acrylic acid, mono-2-(methacryloyloxy) ethyl phthalate, 3-sulphopropyl methacrylic acid, maleic acid, fumeric acid, crotonic acid and mono-2-(acryloyloxy) ethyl phthalate.

Examples of component B) having acid metal chelant groups other than carboxylic acids include bis(2-(methacryloylethyl)phosphate, (methacryloyloxy)ethyl phosphate and 2-acrylamido-2-methyl-1-propane sulphonic acid.

Commercial examples of component B) include Actilane™ 276 (tetra functional urethane acrylate), Actilane™ 320 HD 20 (difunctional epoxy acrylate), Actilane™ 340 (trifunctional epoxy acrylate), Actilane™ 505 (tetrafunctional polyester acrylate), AAEM (acetoacetoxy ethylmethacrylate), Photomer™ 5429 (a polyester tetra acrylate), Actilane™ 820 (difunctional acrylate), Actilane™ 872 (difunctional acrylate), Actilane 890 (pentafunctional melamine acrylate), Photomer™ 5004F (silane acrylate), Sartomer™ 3050 (acidic monoacrylate), mono-2-(methacryloyloxy) ethyl succinate, bis(2-methacryloxy)ethylphosphate, Photomer ™ 4703, 2-hydroxy-3-phenoxy propyl acrylate and diurethane dimethacrylate. Actilane™, Photomer™ and Sartomer™ are trade names of Akros BV, Cognis Inc and Cray Valley Inc, respectively. The precise chemical structure of these commercially available metal adhesion promoting organic compounds is not known but from the description of the products they are believed to contain hydroxy and/or carboxylic acid groups. Many of these commercially available metal adhesion promoting organic compounds are derived from diols and polyols which are esterified by reaction with (meth)acrylate acid and consequently they may contain free (meth)acrylic acid. This free (meth)acrylic acid may be the actual metal adhesion promoting organic compound. However, for the purpose of the invention commercial mixtures containing free (meth)acrylic acid are to be regarded as single compounds, especially regarding their acid values. Most especially component B) is or comprises acrylic acid, methacrylic acid or mono-2-(methacryloyloxy) ethyl phthalate.

Preferably component B) has an acid value in excess of 200 mg KOH/g (e.g.. (meth)acrylic acid).

Preferably the etch-resistant ink comprises from 0 to 30 parts of component B) by weight.

Although the incorporation of component B), is optional, it is preferred that the etch-resistant ink comprises from 0.1 to 50 parts, more preferably from 0.1 to 30 parts of component B) by weight.

It is preferred that the amount of component B) in the etch-resistant ink is not less than 0.25 and especially not less than 0.4 parts by weight. Preferably the amount of component B) is not greater than 20 parts, more preferably not greater than 15 parts and especially not greater than 10 parts by weight.

Where component B) is an acrylate-functional monomer having a chelant group which is an acid (e.g. carboxylic, sulphonic or phosphonic acid) then said acrylate-functional monomer preferably has only one acid group. The acid chelant group enables the etch-resistant printing ink to adhere sufficiently to the metal or alloy surface during etching (as do the other metal chelant groups) but in addition where the polymerised etch-resistant ink is subsequently removed from the metal or alloy surface under alkaline conditions the acid chelant group serves to aid this removal. Preferably the acid group(s) are part of a mono-functional acrylate monomer. Examples of acrylate-functional monomers having a sulphonic groups are vinyl sulphonic acid and styrene sulphonic acid. An example of an acrylate-functional monomers having a phosphonic acid group is vinyl phosphonic acid. In some embodiments it is preferable for component B) to be comprised of at least two metal adhesion promoting organic compounds, especially at least one having an acid metal chelant group and at least one not having an acid metal chelant group. This can allow greater and more independent control of adhesion and removal characteristics.

The polymerised etch-resistant inks may be removed after etching and if so a preferred method uses alkaline conditions which may be aqueous or solvent-based. Solvent-based media generally contain organic amines, especially alkanolamines such as ethanolamine. Preferred organic solvents are polar in nature since this aids their removal in subsequent aqueous rinsing. However, it is much preferred to use aqueous alkaline media, typically comprising alkali metal hydroxides, carbonates and bicarbonates; and/or ammonia or alkyl or aryl substituted ammonium hydroxide.

Where the polymerised etch-resistant ink is removed under alkaline conditions after chemical etching of the metal or alloy it is preferred that the etch-resistant ink should have an acid value of greater than 30 or more preferably greater than 40mg KOH/g. Although inks having an acid value above 150 mg KOH/g may be used, there is generally no advantage in such levels.

Alternative methods for removing the polymerised etch-resistant ink include solvent stripping, heating, abrasion, ultrasound, burning/oxidizing, cutting and plasma treating. Solvent stripping can be performed in non-polar aprotic solvents (e.g. aromatic solvents and halogenated solvents) or in polar aprotic solvents (e.g. dimethyl sulphoxide, dimethyl formamide, n-methyl pyrrolidone etc).

The polymer and/or prepolymer which is component C) is preferably a polymeric material which is compatible with the acrylate-functional monomers represented by component A). It is distinguished from the acrylate-functional monomers represented by component A) in that component C) is devoid of (unpolymerised) acrylate-functionality. Further, component C) is distinguished from the surfactant (component F) in that component C) is not appreciably surface-active. The polymer or prepolymer typically has a number average molecular weight of from 500 to about 100,000. Preferably the molecular weight is not greater than 30,000 and especially not greater than 10,000. It is also preferred that the molecular weight is not less than 700 and especially not less than 1,000. The polymeric material may belong to any class of resin, for example it may be a polyurethane, polyester, polyimide, polyamide, epoxy, silicone-containing resin or fluorinated resin material, including a mixture thereof. Although it is not a prerequisite that component C) exhibits aqueous alkali solubility this is much preferred since it aids removal of the final etch-resistant ink. In some instances where component C) reacts with or strongly intercalates with the polymer formed by the acrylate-functional monomers and the metal adhesion promoting organic compound represented by components A) and B) aqueous alkali solubility of component C) is unnecessary.

It is preferred that the amount of component C), when present, is not greater than 10 parts, more preferably not greater than 5 parts and especially not greater than 3 parts by weight. It is especially preferred that the ink contains no component C), i.e. the number of parts of component C) is zero.

The radical initiator represented by component D) may be any compound capable of generating radicals. Preferred radical initiators are those which initiate polymerisation of acrylate-functional monomers. The radical initiator, when present, may be activated by actinic radiation (such as UV radiation) or by accelerated particles (for example electron beam radiation).

Suitable sources of actinic radiation include mercury lamps, xenon lamps, carbon arc lamps, tungsten filament lamps, lasers, electron beam and sunlight. Ultraviolet (UV) radiation is preferred especially that emitted by medium pressure mercury lamps.

Preferably the radical initiator is a photo-initiator activated by UV light.

Examples of suitable radical initiators are anthraquinone, substituted anthraquinone, such as alkyl and halogen substituted anthraquinones such as 2-tert butyl anthraquinone, 1-chloroanthraquinone, p-chloroanthraquinone, 2-methylanthraquinone, 2-ethylanthraquinone octamethyl anthraquinone and 2-amylanthraquinone, optionally substituted polynuclear quinones such as 1,4-naphthoquinone, 9,10-phenanthraquinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, 3-chloro-2-methylanthraquinone, retenequinone, 7,8,9,10-tetrahydronapthaanthraquinone, 1,2,3,4-tetrahydro benzanthracene-7.2-dione, acetophenones such as acetophenone, 2,2-dimethyoxy-2-phenyl acetophenone, 2,2-diethoxy-2-phenyl acetophenone, 1,1-dichloro acetophenone, 1-hydroxy cyclothexyl-phenylketone and 2-methyl-1-(4-methylthio)phenyl-2-morpholin-propan-1-one; thioxanthones such as 2-methylthioxanthone, 2-decylthioxanthone, 2-dodecylthioxanthone, 2-isopropylthioxanthone, 2,4-dimethylthioxanthone, 2,4-diethylthioxanthone, 2-chlorothioxanthone and 2,4-diisopropylthioxanthone; ketals such as acetophenone dimethylketal and dibenzylketal; benzoins and benzoin alkyl ethers such as benzoin, benzyl benzoin methyl ether, benzoin isopropyl ether and benzoin isobutyl ether; azo compounds such as azobisisovaleronitrile; benzophenones such as benzophenone, methylbenzophenone, 4,4'-dichlorobenzophenone, 4,4[1]-bis-diethyl amino benzophenone, Michler's ketone and xanthone, including mixtures thereof. Important commercial photoinitiators which can be activated by UV light include Irgacure™ 184, 369, 907 and 1850; Darocure™ 1173 and Speedcure™ DETX, ITX, CTX and CPTX. Irgacure™

and Darocure ™ are registered trademarks of Ciba GmbH, whilst Speedcure™ is a registered trademark of Lambson Plc.

Component D) can comprise one or more than one radical initiator. Thioxanthones are generally used in combination with other types of initiators. Preferably component D) comprises a thioxanthone radical initiator (especially Speedcure™ ITX) and a radical initiator other than a thioxanthone radical initiator.

The amount of radical initiator is preferably not greater than 18 parts, more preferably not greater than 15 parts and especially not greater than 10 parts by weight. It is also preferred that the amount of radical initiator is not less than 0.1 parts by weight.

When component B) contains a carboxylic acid group it is sometimes advantageous to supply the ink in the form of a "two-pack" formulation where component B) and component D) are separated since this provides for enhanced storage stability. The final etch-resistant ink can then be formulated immediately prior to use by mixing the two packs. When the ink is supplied as a two-pack formulation component D) is preferably supplied in admixture with all or part of component A), especially the mono-functional monomers.

Component E) of the etch-resistant ink is preferably a pigment and may be organic or inorganic, including pigments with surface modification which facilitates self dispersion in the ink. The pigment may be from any of the recognised classes of pigments described, for example, in the Third Edition of the Colour Index (1971) and subsequent revisions of and supplements thereto under the chapter headed "Pigments". Examples of inorganic pigments are titanium dioxide, Prussian blue, cadmium sulphide, iron oxides, vermillion, ultramarine and the chrome pigments, including chromates, molybates and mixed chromates and sulphates of lead, zinc, barium, calcium and mixtures and modifications thereof which are commercially available as greenish-yellow to red pigments under the names primrose, lemon, middle, orange, scarlet and red chromes. Examples of organic pigments are those from the azo, diazo, condensed azo, thioindigo, indanthrone, isoindanthrone, anthanthrone, anthraquinone, isodibenzathrone, triphendioxazine, quinacridone and phthalocyanine series, especially copper phthalocyanine and its nuclear halogenated derivatives; and also lakes of acid, basic and mordent dyes. Carbon black, although strictly inorganic, behaves more like an organic pigment in its dispersing properties. Preferred organic pigments are phthalocyanines, especially copper phthalocyanines, monoazos, diazos, indanthrones, anthanthrones, quinacridones and carbon blacks.

The pigment is typically incorporated into the etch-resistant ink by milling it together with component A) in the presence of a dispersant. The dispersant is preferably a polyester/polyamine and is, for example, a dispersant as disclosed in US 6,197,877. Dispersants of this type are available under the trademark Solsperse™ dispersants (Solsperse is a trade mark of Lubrizol). The dispersant may also include a dispersant synergist such as a quaternary ammonium salt of a partially sulphonated copper phthalocyanine pigment. Examples of such dispersant synergists are disclosed in GB-A-1508576, GB-A-2108143 and WO 01/14479 and are available under the Solsperse™ trademark.

The ratio of dispersant to dispersant synergist is typically from 1:1 to 10:1 by weight and is preferably about 5:1 by weight. The total amount of dispersant and dispersant synergist to pigment may vary over wide limits and is typically from 50% to 150% by weight relative to the weight of pigment.

The amount of colorant in the etch-resistant ink is preferably not greater than 4 parts, more preferably not greater than 3 parts and especially not greater than 2 parts by weight.

Component F) of the etch-resistant ink ; when present, may be any surface-active material which aids the homogeneity of the ink and provides desirable surface tension and wetting properties to the resultant ink. The surfactant may also be selected to adjust the firing characteristics of the ink composition to the desired limits. The surfactant is preferably anionic or especially non-inonic and is preferably aliphatic in nature, optionally containing silicon and/or fluorine atoms.

The surfactant is preferably reactive with the acrylate-functional monomers (component A) and it is especially preferred that the surfactant contains one or more (meth)acrylate-functional groups as defined hereinbefore. Preferred surfactants containing silicon atoms are organic silicone acrylates. Examples of organic silicone acrylate surfactants are polysilicones, specific examples are Tegorad™ 2200N and 2100 available from Tego Chemie.

Where the presence of a metal adhesion promoting organic compound is optional a preferred embodiment of the present invention is a process for etching a metal or alloy surface which comprises applying an etch-resistant ink by ink jet printing to selected areas of the metal or alloy, exposing the etch-resistant ink to actinic radiation and/or particle beam radiation to effect polymerisation, optionally thermally treating the etch-resistant ink and then removing the exposed metal or alloy by a chemical etching process wherein the etch-resistant ink is substantially solvent-free and comprises the components:

    A) 30 to 90 parts acrylate-functional monomers;
    B) 0 to 30 parts metal adhesion promoting organic compound;
    C) 0 to 20 parts polymer and/or prepolymer,
    D) 0 to 20 parts radical initiator;
    E) 0 to 5 parts colorant; and
    F) 0 to 5 parts surfactant;

wherein the ink has a viscosity of not greater than 30 cPs (mPa.s) at 40°C, all parts are by weight and the total number of parts A)+B)+C)+D)+E)+F) = 100, provided that when the metal or alloy is supported by a non-etchable substrate it does not constitute a printed circuit board; with the proviso that the process is not a process for making an electronic device comprising a dielectric substrate laminated with an electrically conductive metal or alloy which comprises applying a non-aqueous etch-resistant ink by ink jet printing to selected areas of the metal or alloy, exposing the etch-resistant ink to actinic radiation and/or particle beam radiation to effect polymerisation, removing exposed metal or alloy by a chemical etching process and then removing the polymerised etch-resistant ink by alkali wherein the etch-resistant ink is substantially solvent free and comprises the components:

A) 30 to 90 parts acrylate functional monomers free from acid groups comprising mono or higher functionality wherein 5 - 95% by weight is one or more mono-functional monomers;
B) 1 to 30 parts acrylate functional monomer containing one or more acid groups;
C) 0 to 20 parts polymer or prepolymer;
D) 0 to 20 parts radical initiator;
E) 0 to 5 parts colorant;
F) 0 to 5 parts surfactant; and

wherein the ink has a viscosity of not greater than 30 cPs (mPa.s) at 40°C and all parts are by weight.

Preferably in the above embodiment the etch-resistant ink comprises from 0.1 to 30 parts by weight of metal adhesion promoting organic compound.

An especially preferred embodiment of the present invention is a process for etching a metal or alloy surface which comprises applying a non-aqueous etch-resistant ink by ink jet printing to selected areas of the metal or alloy, exposing the etch-resistant ink to actinic radiation and/or particle beam radiation to effect polymerisation, optionally thermally treating the etch-resistant ink and then removing the exposed metal or alloy by a chemical etching process wherein the etch-resistant ink is substantially solvent-free and comprises the components:

A) 30 to 90 parts acrylate-functional monomers comprising mono or higher functionality wherein 5 to 95% by weight is one or more mono-functional monomers;
B) 0.1 to 30 parts metal adhesion promoting organic compound;
C) 0 to 20 parts polymer and/or prepolymer;
D) 0 to 20 parts radical initiator;
E) 0 to 5 parts colorant; and
F) 0 to 5 parts surfactant;

wherein the ink has a viscosity of not greater than 30 cPs (mPa.s) at 40°C, all parts are by weight and the total number of parts A)+B)+C)+D)+E)+F) = 100, provided that where the metal or alloy is supported by a non-etchable substrate, it does not constitute a printed circuit board; with the proviso that the process is not a process for making an electronic device comprising a dielectric substrate laminated with an electrically conductive metal or alloy which comprises applying a non-aqueous etch-resistant ink by ink jet printing to selected areas of the metal or alloy, exposing the etch-resistant ink to actinic radiation and/or particle beam radiation to effect polymerisation, removing exposed metal or alloy by a chemical etching process and then removing the polymerised etch-resistant ink by alkali wherein the etch-resistant ink is substantially solvent free and comprises the components:

A) 30 to 90 parts acrylate functional monomers free from acid groups comprising mono or higher functionality wherein 5 - 95% by weight is one or more mono-functional monomers;
B) 1 to 30 parts acrylate functional monomer containing one or more acid groups;
C) 0 to 20 parts polymer or prepolymer;
D) 0 to 20 parts radical initiator;
E) 0 to 5 parts colorant;
F) 0 to 5 parts surfactant; and

wherein the ink has a viscosity of not greater than 30 cPs (mPa.s) at 40°C and all parts are by weight.

The etch-resistant ink preferably has a surface tension of from 20 to 40 and especially between 25 and 35 mN/m. Consequently, the amount of component F) is generally from 0.0 to 0.6 parts.

The etch-resistant ink may of course contain further ingredients which are commonly used in actinic radiation or particle beam curable compositions in addition to components A) to F) specified above. Such ingredients include slip modifiers, thixotropic agents, anti-foaming agents, waxes, oils, plasticisers, antioxidants, photo-initiator stabilisers, radical initiator synergists, gloss agents, fungicides, bactericides, organic and/or inorganic filler particles, levelling agents, opacifiers and antistatic agents.

The radical initiator synergist is preferably present in combination with a radical initiator. The function of the radical initiator synergist is to speed the generation of radicals resulting from the decomposition of the radical initiator.

Preferred synergists are amines and especially aminobenzoate type synergists. Preferred commercially available synergists include Speedcure™ BEDB, DMB, EDB and especially EHA available from Lambson Fine Chemicals Ltd.

The amount of radical initiator synergist is preferably from 0.1 to 10 parts, more preferably from 1 to 8 parts and especially from 2 to 6 parts by weight.

One or more radical initiator synergists may be used.

The metal or alloy is preferably any of those suitable for PCM and includes metals and their alloys from the Periodic Table group IA, group IIA, group IIIB, group IVB, groups VB, group VIB, the transition metals, the lanthanides and actinides according to Mendeleof, as published for example on the rear inside cover of The Handbook of Chemistry and Physics, The Chemical Rubber Company, 49th Edition, 1968-9.

Prior to applying the etch-resistant ink to the metal or alloy, the metal surface is preferably cleaned, e.g. by any method known to the art, including rinsing in organic solvent, rinsing with aqueous detergent solution, mechanical abrasion such as sandblasting, micro-etching with aqueous acids (e.g. HCl and $H_2SO_4$) and aqueous oxidative cleaning with, for example, persulphate or perborate.

Suitable metals and alloys include aluminium, bronze, beryllium, chromium, columbium, constantan, copper and copper alloys, gold, nickel and nickel alloys, lead, magnesium, molybdenum, niobium, platinum, silver, stainless steel, mild steel, tin, titanium, tungsten, vanadium, zinc and zirconium. Preferred metals and alloys are stainless steel, mild steel, beryllium, beryllium copper, copper, Iconel, Kovar, Monel and other nickel alloys; nickel, aluminium, brass, molybdenum and titanium. Ferro metals and alloys are especially preferred.

The metal or alloy is preferably not supported by a non-etchable substrate.

The etch-resistant ink may be prepared by any method known to the art of actinic radiation or particle beam curable compositions. Typically, components A) and B) are mixed together with rapid stirring at a temperature from 20 to 60°C, preferably under reduced light conditions until a homogenous solution is obtained. Component D), when present, is then added and stirring continued at 20 to 60°C under reduced light conditions. Finally, components C), E) and F) and any further ingredients , if required, are added.

As noted hereinbefore, component E) is preferably a pigment and is preferably prepared by any suitable attrition process such as grinding, pebble or bead milling the pigment together with dispersant in the presence of small amounts of component A) and/or component B). When component E) is a pigment it is preferably added to the other components of the ink in a pre-dispersed form. The etch-resistant ink is then preferably filtered at 20 to 25°C to remove any oversized particulate matter. Filtration also includes a process known as cascade filtration when the etch-resistant ink passes through successively finer filter media, for example, 10, 6, 4.5, 2.5 and 1.2 micron filters.

The etch-resistant ink may be polymerised at any stage following ejection of droplets of the ink from the printhead and includes both in-flight and post-flight exposure of the droplets to particle beam radiation and especially actinic radiation.

The etch-resistant ink is polymerised by exposure to actinic radiation and/or particle beam radiation. Optionally the etch-resistant ink can be thermally treated to force the polymerisation or cure still further. A preferred temperature for the thermal treatment is from 50 to 300°C, more preferably 80 to 200°C. When thermal treatment is utilised it is preferably to incorporate thermally reactive cross-linking groups or compounds into the etch-resistant ink composition. Preferred thermally reactive cross-linking groups include epoxide, silane, melamine, carbodiimine, isocyanate and aziridine groups.

After polymerisation of the etch-resistant ink by exposure to actinic radiation and/or particle beam radiation (e.g. electron beam), the metal or alloy is subjected to a chemical etching process to remove those parts of the metal or alloy which are not protected by the polymerised etch-resistant ink. The removal of this metal or alloy results in the desired etch pattern, which may be restricted to the surface or may fully penetrate the metal or alloy.

The chemical etching may be carried out by any means appropriate to the metal or alloy concerned. Table 1 summarises the preferred etchants for preferred metals and alloys.

TABLE 1

| Metal/Alloy | Preferred etch conditions* | Temperature °C |
|---|---|---|
| Stainless steel (many grades) | 35-42°Bé $FeCl_3$ | 35-55 |
| Mild steel | 35-42°Bé $FeCl_3$ | 35-55 |
| Beryllium copper | 30-42°Bé $FeCl_3$ or ammoniacal copper or 33°Bé acidic $CuCl_2$ | 40-55 |

(continued)

| Metal/Alloy | Preferred etch conditions* | Temperature °C |
|---|---|---|
| Copper and copper alloys | 30-42°Bé $FeCl_3$ or ammoniacal copper or 33°Bé acidic $CuCl_2$ | 40-55 |
| Inconel and other high nickel alloys | 38-42°Bé $FeCl_3$ or conc nitric/conc hydrochloric acid/water 1:3 | 45-55 |
| Aluminium | 20% NaOH or conc hydrochloric acid/water 1:4 or alkaline potassium ferricyanide | 60-90 20-65 55 |
| Brass | 30-42°Bé $FeCl_3$ or ammoniacal copper or 33°Bé acidic $CuCl_2$ | 40-55 |
| Molybdenum | Alkaline potassium ferricyanide or 400Bé $Fe(NO_3)_3$ | 55 40-55 |
| Titanium | 10-50% HF (optionally with $HNO_3$) | 30-50 |

The concentration of etchant (column 2) is measured in Degrees Baume (°Bé) where:

$$^o\text{Bé} = 145 \, (SG - 1/SG);$$

and
SG is the specific gravity (density) of the solution.
Etching is typically carried out at a temperature from 20 to 100°C although it is preferably between 25 and 60°C and includes spraying or dipping where the metal or alloy may be contacted with the chemical etchant when in either the horizontal or vertical position. Spraying is preferred, especially where the metal or alloy is in the vertical position since this allows for quicker removal of the chemical etchant containing removed metal and/or alloy. The speed of etching may be accelerated by agitating the chemical etchant, for example, using sonic agitation.

Depending on the requirements of the specific application the etching may or may not proceed through the entire thickness of the metal or alloy.

After the metal or alloy has been treated with the chemical etchant the metal or alloy is preferably rinsed with water to remove traces of the etchant. Where the polymerised etch-resistant ink is removed a preferred method is via chemical treatment. A more preferred method for removing the etch-resistant ink is treatment using alkaline conditions. Typically alkali treatment is performed at a temperature from 0 to 100°C, preferably 40 to 60°C to remove the etch-resistant polymer. Finally, the metal or alloy is rinsed with water and dried.

In embodiments where a non-etchable substrate has been used, said substrate is preferably removed at some point after etching. The non-etchable substrate is preferably a non-metallic material, more preferably a ceramic, glass, wood, textile, wax, paper, plastics material or rubber material. Preferably the textile is in the form of a woven mat.

The process according to the present invention may be used to prepare an article having a chemically etched surface pattern or design. Examples of specific articles are a grid, a filter, a graticule, a mesh, a light chopper disc, a heat sink plate, a heater element, a screen, colour TV mask, a diaphragm, a shim, a gasket, a washer, a spring, a link, a probe, a magnetic recording head, a circuit lead frame, an encoder disc, an item of jewellery, a rule, a scale, a clutch plate, an emitter contact, a micro reactor, a suspension lead, an ink jet nozzle plate, a stencil, a razor foil, a bearing, an edge filter, a logo, a nameplate, a decorative plaque, an instrument case, a box, an enclosure or a potentiometer case made by the process of the present invention.

The etch-resistant ink used in the present invention may be used in other related etching processes such as glass etching, ceramic etching, visual displays, silicon etching, micro-reactor fabrication, analytical device manufacture, sensor manufacture, organic semi-conductor patterning, inorganic semi-conductor patterning and dielectric patterning.

The presently claimed process has a number of advantages compared to PCM, e.g. it removes the need for a photo-tool. The image, or negative image, is made digitally available direct from a computer. The number of processing steps is greatly reduced and the need for differential stripping of the photo-resist using different strengths of aqueous alkali is avoided. As there is no photo-tool there is the potential for improved definition and density of any fine detail. There also exists the cost saving in terms of etch-resist ink because the ink is applied selectively only to those areas to be protected from chemical etching.

Commercially available UV curable ink jet inks often contain organic solvents to lower the viscosity of the ink.

However such inks suffer from odour, flammability and toxicological disadvantages. Furthermore the presence of organic solvents can in some cases adversely affect adhesion between the etch-resist ink and the metal or alloy substrate and reduce the definition of finer etched details. The present invention does not require solvents to be included in the etch-resistant ink and therefore overcomes the deficiencies of conventional UV curable inks used in other technical fields.

The invention is further illustrated by the following non-limiting examples wherein all parts are by weight unless expressed to the contrary.

Examples 1 to 6

Etch-resistant inks were prepared having the formulations described in Table 2 below. The acrylate-functional monomers (components 1 to 4) and metal adhesion promoting organic compounds (components 5 to 8) were mixed together at 25°C with stirring to obtain a homogenous solution. The radical initiators and radical initiator synergists (components 9 to 12) were then added and the mixture stirred at 60°C under reduced light until the radical initiators were dissolved. The mixture was then cooled to 25°C and the surfactant (component 13) was added to give a liquid medium. A dispersion of the colorant (component 14) was prepared by milling the colorant and dispersant (component 15 and 16) in the presence of 3mm diameter glass beads and a relatively small amount of acrylate-functional monomers (1 to 4). This dispersion was then added to the liquid medium (components 1 to 13) and thoroughly mixed under reduced light. Finally, the mixture was cascade filtered through a series of fibre glass filters having a pore size of 10, 6, 4.5, 2.5 and 1.2μ to remove any oversized particulate matter.

TABLE 2

| Expressed in parts by weight. | | | | | | | |
|---|---|---|---|---|---|---|---|
| No. | Example | 1 | 2 | 3 | 4 | 5 | 6 |
| Acrylate-Functional Monomers | | | | | | | |
| 1 | Sartomer 506 | 34.9 | 29.9 | 40.48 | 29.9 | 29.9 | 29.9 |
| 2 | Sartomer 306 | 23 | 23 | 12.98 | 23 | 23 | 23 |
| 3 | Actilane 430 | 12.5 | 12.5 | 26.00 | 12.5 | 12.5 | 12.5 |
| 4 | Actilane 251 | 12.5 | 12.5 | 2.00 | 12.5 | 12.5 | 12.5 |
| Metal adhesion promoting organic compounds | | | | | | | |
| 5 | Acrylic acid | 5 | 10 | 4.90 | | | |
| 6 | Methacrylic acid | | | | 10 | | |
| 7 | Itaconic acid | | | | | 10 | |
| 8 | Maleic acid | | | | | | 10 |
| Radical Initiators and radical initiator synergists | | | | | | | |
| 9 | Speedcure ITX | 2 | 2 | | 2 | 2 | 2 |
| 10 | Speedcure EHA | 4 | 4 | | 4 | 4 | 4 |
| 11 | Irgacure 369 | 4 | 4 | 5 | 4 | 4 | 4 |
| 12 | Irgacure 184 | | | 5 | | | |
| Surfactants | | | | | | | |
| 13 | Tegorad 2200N | 0.4 | 0.4 | 0.4 | 0.4 | 0.4 | 0.4 |
| Colorants | | | | | | | |
| 14 | Irgalite Blue GLVO | 1 | 1 | 2 | 1 | 1 | 1 |
| 15 | Solsperse 32000 | 0.59 | 0.59 | 1.2 | 0.59 | 0.59 | 0.59 |
| 16 | Solsperse 5000 | 0.11 | 0.11 | 0.04 | 0.11 | 0.11 | 0.11 |

Examples 7 to 15

Etch-resistant inks were prepared having the formulations described in Table 3 below. The acrylate-functional monomers (components 1 to 7) and the metal adhesion promoting organic compounds (components 8 to 12) were mixed together at 25°C with stirring to obtain a homogenous solution. The radical initiators and radical initiator synergists (components 13 to 16) were then added and the mixture stirred at 60°C under reduced light until the radical initiators were dissolved. The mixture was then cooled to 25°C and the surfactant (component 17) was added to give a liquid medium. A dispersion of the colorant (component 18) was prepared by milling the colorant and dispersant (component 19 and 20) in the presence of 3mm diameter glass beads and a relatively small amount of acrylate-functional monomer (1 to 7). This dispersion was then added to the liquid medium (components 1 to 17) and thoroughly mixed under reduced light. Finally, the mixture was cascade filtered through a series of fibre glass filters having a pore size of 10, 6, 4.5, 2.5 and 1.2μ to remove any oversized particulate matter.

TABLE 3

| Expressed in parts by weight. | | | | | | | | | | |
|---|---|---|---|---|---|---|---|---|---|---|
| No. | Example | 7 | 8 | 9 | 10 | 11 | 12 | 13 | 14 | 15 |
| Acrylate Monomers | | | | | | | | | | |
| 1 | Sartomer 506 | 13.48 | 28.98 | 28.98 | 28.98 | 28.98 | 18.98 | 18.98 | 8.98 | 18.98 |
| 2 | Sartomer 306 | 12.98 | 12.38 | 12.38 | 12.38 | 12.38 | 12.38 | 12.38 | 12.38 | 12.38 |
| 3 | Actilane 430 | 25 | 20 | 20 | 20 | 20 | 20 | 20 | 20 | 25 |
| 4 | Actilane 251 | 30 | | | | | | | | |
| 5 | Photomer 6623 | | | 20 | | | | | | |
| 6 | Photomer 3005F | | | | 20 | | | 30 | 40 | |
| 7 | Photomer 4025 | | | | | 20 | | | | |
| Metal adhesion promoting organic compounds | | | | | | | | | | |
| 8 | Acrylic acid | 4.9 | 5 | 5 | 5 | 5 | 5 | 5 | 5 | |
| 9 | Methacrylic acid | | | | | | | | | |
| 10 | Itaconic acid | | | | | | | | | |
| 11 | Maleic acid | | | | | | | | | |
| 12 | MAEPhth | | 20 | | | | 30 | | | 30 |
| Radical Initiators and radical initiator synergists | | | | | | | | | | |
| 13 | Speedcure ITX | | | | | | | | | |
| 14 | Speedcure EHA | | | | | | | | | |
| 15 | Irgacure 369 | 5 | 5 | 5 | 5 | 5 | 5 | 5 | 5 | 5 |
| 16 | Irgacure 184 | 5 | 5 | 5 | 5 | 5 | 5 | 5 | 5 | 5 |
| Surfactants | | | | | | | | | | |
| 17 | Tegorad 2200N | 0.4 | 0.4 | 0.4 | 0.4 | 0.4 | 0.4 | 0.4 | 0.4 | 0.4 |
| Colorants | | | | | | | | | | |

(continued)

| Expressed in parts by weight. | | | | | | | | | | |
|---|---|---|---|---|---|---|---|---|---|---|
| No. | Example | 7 | 8 | 9 | 10 | 11 | 12 | 13 | 14 | 15 |
| Acrylate Monomers | | | | | | | | | | |
| 1 | Sartomer 506 | 13.48 | 28.98 | 28.98 | 28.98 | 28.98 | 18.98 | 18.98 | 8.98 | 18.98 |
| 18 | Irgalite Blue GLVO | 2 | 2 | 2 | 2 | 2 | 2 | 2 | 2 | 2 |
| 19 | Solsperse 32000 | 1.2 | 1.2 | 1.2 | 1.2 | 1.2 | 1.2 | 1.2 | 1.2 | 1.2 |
| 20 | Solsperse 5000 | 0.04 | 0.04 | 0.04 | 0.04 | 0.04 | 0.04 | 0.04 | 0.04 | 0.04 |

Product Trade Names

Irgacure™ 184 is the trade name for (1-hydroxycyclohexyl)phenyl methanone from Ciba GmbH.

Irgacure™ 369 is the trade name for 2-benyl 2-climethylamino 1-(4-morpholino phenyl) butanone-1 from Ciba GmbH.

Photomer™ 6623 is the tradename for an aliphatic urethane acrylate from Cognis Inc.

Photomer™ 3005F is the tradename for an acrylated epoxy soya oil from Cognis Inc.

Photomer™ 4025 is the tradename for a bisphenol-A(8) ethoxylated diacrylate from Cognis Inc.

MAEPhth is mono-2-(methacryloyloxy)ethyl phthalatye available from Aldrich.

The properties of inks described in Examples 1 to 15 above are shown in Tables 4 and 5 below. The viscosity of the ink was measured at 40°C using a Brookfield viscometer equipped with No. 18 spindle rotating at 100 rpm. Surface tension was measured at 25°C using a DuNony ring and jettability/ink performance was assessed after start-up and firing using a Spectra Galaxy 30pt print head using a visually assessed scale of good, moderate and poor.

TABLE 4

| Example | 1 | 2 | 3 | 4 | 5 | 6 |
|---|---|---|---|---|---|---|
| Viscosity at 40°C (mPa.s) | 12.0 | 13.6 | 13 | 11.4 | | |
| ST (mN/m) | 26.0 | 25.5 | 26 | | | |
| Pencil Hardness | 4H | 6H | 2H | 2H | | |
| Adhesion | good | good | good | good | good | good |
| Etch Resistance | yes | yes | yes | | | |
| Alkaline Strip | yes | yes | yes | yes | | |

TABLE 5

| Example | 7 | 8 | 9 | 10 | 11 | 12 | 13 | 14 | 15 |
|---|---|---|---|---|---|---|---|---|---|
| Viscosity at 40°C (mPa.s) | 31.3 | 41.3 | 39.1 | 41.7 | 26.6 | 71.5 | 83.4 | 157.0 | 64.7 |
| ST (mN/m) | 23.5 | 25.0 | 23.0 | 26.0 | 25.0 | 25.5 | 25.0 | 25.5 | 25.5 |
| Pencil Hardness | 6H | 9H | 6H | 4H | 7H | 9H | 5H | F | 6H |
| Adhesion | good | good | good | good | good | good | good | good | good |
| Etch Resistance | yes | yes | yes | yes | yes | yes | yes | yes | yes |
| Alkaline Strip | yes | yes | yes | yes | yes | yes | yes | yes | yes |

Table 4 and Table 5 show ink Examples 1 to 6 with viscosities suitable for ink jet firing, surface tensions suitable for ink jet firing and which in practice demonstrate good ink jet firing performance.

Stainless steel boards (both mirrored and non-mirrored) were prepared by cleaning the surface with acetone.

The inks in Examples 1 to 6 were applied to 50% of the area of both types of stainless steel boards to a thickness of 24μ using a K-bar. Each ink was then polymerised by UV light exposure at 300-900 mJ/cm (or 2.8-3.6W/cm$^2$ at a pass speed of 5m/min) using a "Fusion D bulb" running at 120W/cm.

The steel boards were then cut using tin snips into sections of 2cm x 4cm ensuring approximately 50% of the board was covered in etch-resistant ink and approximately 50% was uncovered.

Each section was placed into a bottle containing ferric chloride etch solution (3molL$^{-1}$) at approximately 60°C and the bottle lid sealed. Each bottle was shaken vigorously under a hot tap for a duration of 0, 2, 5, 10 and 30 minutes as indicated in Table 6, column 2.

After etching the steel sections were removed from the etchant, rinsed in cold water and cleaned with a paper towel to remove any surface residue to produce etched steel boards. Any damage to the etch-resistant ink was visually quantified and recorded (Table 6, column 4). The etch depth was measured (Table 6, column 3) and was seen to increase with increasing etch time.

Alkali removal of the polymerised etch-resistant ink was assessed by placing etched steel boards in an aqueous (2.5% by weight) NaOH solution at 60°C in sealed bottles. The bottles were agitated under a hot tap until the etch-resistant ink had been stripped from the steel surface. The time taken for stripping was measured (Table 6, column 5) and the difference in thickness of the board at the etched and un-etched surfaces was measured (Table 6, column 6).

TABLE 6

| Stainless steel type | Etch time mins | Etch depth / μm | Etch resist damage | 2.5% NaOH strip time / mins & secs | Step / μm |
|---|---|---|---|---|---|
| Non-mirrored | 0 | 0 | N/A | 2.30 | N/A |
| | 2 | 29 | v. slight | 2.30 | 23 |
| | 5 | 66 | v. slight | 2.10 | |
| | 10 | 82 | slight | 2.30 | 53 |
| | 30 | 201 | slight | N/A | N/A |
| Mirrored | 0 | 0 | N/A | 2.00 | N/A |
| | 2 | 44 | v. slight | 1.45 | 26 |
| | 5 | 96 | slight | 1.45 | 67 |
| | 10 | 123 | slight | 2.10 | 99 |
| | 30 | 233 | slight | N/A | N/A |

Table 6 shows typical etch data obtained from ink examples 1 to 6. More specifically, Table 6 shows that the ink gives good etch depth (column 3) with etch time (column 2) whilst not etching the areas protected by the etch-resistant ink (column 6). During etching the etch-resistant ink demonstrated excellent adhesion and resistance to damage (column 4) and the etch-resistant ink had excellent alkali removability (column 5).

**Claims**

**1.** A process for etching a metal or alloy surface which comprises applying an etch-resistant ink by ink jet printing to selected areas of the metal or alloy, exposing the etch-resistant ink to actinic radiation and/or particle beam radiation to effect polymerisation, optionally thermally treating the etch-resistant ink and then removing the exposed metal or alloy by a chemical etching process wherein the etch-resistant ink is substantially solvent-free and comprises the components:

    A) 30 to 90 parts acrylate-functional monomers;
    B) 0 to 50 parts metal adhesion promoting organic compound; .
    C) 0 to 20 parts polymer and/or prepolymer,
    D) 0 to 20 parts radical initiator;
    E) 0 to 5 parts colorant; and
    F) 0 to 5 parts surfactant;

wherein the ink has a viscosity of not greater than 200 cPs (mPa.s) at 40°C, all parts are by weight and the total number of parts A)+B)+C)+D)+E)+F) = 100, provided that when the metal or alloy is supported by a non-etchable substrate it does not constitute a printed circuit board; with the proviso that the process is not a process for making an electronic device comprising a dielectric substrate laminated with an electrically conductive metal or alloy which comprises applying a non-aqueous etch-resistant ink by ink jet printing to selected areas of the metal or alloy, exposing the etch-resistant ink to actinic radiation and/or particle beam radiation to effect polymerisation, removing exposed metal or alloy by a chemical etching process and then removing the polymerised etch-resistant ink by alkali wherein the etch-resistant ink is substantially solvent free and comprises the components:

    A) 30 to 90 parts acrylate functional monomers free from acid groups comprising mono or higher functionality wherein 5 - 95% by weight is one or more mono-functional monomers;
    B) 1 to 30 parts acrylate functional monomer containing one or more acid groups;
    C) 0 to 20 parts polymer or prepolymer;
    D) 0 to 20 parts radical initiator;
    E) 0 to 5 parts colorant;
    F) 0 to 5 parts surfactant; and

wherein the ink has a viscosity of not greater than 30 cPs (mPa.s) at 40°C and all parts are by weight.

2. A process as claimed in claim 1 wherein the etch-resistant ink comprises from 0.1 to 50 parts of component B) by weight.

3. A process as claimed in claim 1 wherein the etch-resistant ink comprises from 0 to 30 parts of component B) by weight.

4. A process as claimed in claim 1 wherein the etch-resistant ink comprises from 0.1 to 30 parts of component B) by weight.

5. A process as claimed in any one of claims 1 to 4 wherein the etch-resistant ink is non-aqueous.

6. A process as claimed in any one of claims 1 to 5 wherein component A) comprises 5 to 95% by weight of one or more mono-functional acrylate monomers, relative to the total weight of component A).

7. A process as claimed in any one of the preceding claims wherein the etch-resistant ink has a viscosity of not greater than 30cPs (mPa.s) at 40°C.

8. A process as claimed in any one of claims 1 to 7 wherein the metal or alloy surface is not supported by a non-etchable substrate or where the metal or alloy is so supported the non-etchable substrate is removed after the etching process.

9. A process as claimed in any one of claims 1 to 8 wherein component A) comprises 70 to 95% by weight of one or more mono-functional acrylate monomers, relative to the total weight of component A).

10. A process as according to any one of the preceding claims wherein all of the acrylate-functional monomers of Component A) have weight average molecular weights of not greater than 2,000

11. A process according to any one of the preceding claims wherein component A) comprises at least one monomer selected from isobornyl acrylate, tripropylene glycol diacrlylate and trimethylol propane ethoxylate triacrylate.

12. A process according to any one of the preceding claims wherein component A) comprises an acrylate-functional urethane oligomer.

13. A process according to any one of the preceding claims wherein the metal adhesion promoting organic compound is an acrylate-functional monomer.

14. A process according to any one of the preceding claims wherein the metal adhesion promoting organic compound has a metal chelant group which is a carboxylic acid.

15. A process according to claim 14 wherein the metal adhesion promoting organic compound is or comprises methacrylic acid, acrylic acid or mono-2-(methacryloyl)ethyl phthalate.

**16.** A process according to any one of the preceding claims wherein the amount of metal adhesion promoting organic compound is not greater than 10 parts by weight.

**17.** A process according to any one of the preceding claims wherein the radical initiator is a photo-initiator activated by UV light.

**18.** A process according to any one of the preceding claims wherein the surfactant is an organic silicone acrylate surfactant.

**19.** A process according to any one of the preceding claims wherein the etch-resistant ink has a surface tension of from 20 to 40 mN/m.

**20.** A process according to any one of the preceding claims wherein the viscosity of the etch-resistant ink is from 8 to 15 cPs (mPa.s) at 40°C.

**21.** A process according to any one of the preceding claims wherein component B) has an acid value in excess of 200mg KOH/g.

**22.** A process according to any one of the preceding claims wherein the etch-resistant ink has an acid value of greater than 30 mg KOH/g.

**23.** A process according to any one of the preceding claims wherein the number of parts of component C) is zero.

**24.** A process according to any one of the preceding claims which includes the thermal treatment carried out at a temperature from 80°C to 200°C.

**25.** A process according to any one of the preceding claims wherein the etching process does not proceed through the entire thickness of the metal or alloy.

**26.** A process according to any one of the preceding claims wherein the polymerised etch-resistant ink applied to selected areas of the metal or alloy surface is subsequently removed from the metal or alloy.

**27.** A process according to claim 26 wherein the polymerised etch-resistant ink is removed from the metal or alloy by treatment using alkaline conditions.

**28.** A process according to any one of the preceding claims wherein the metal or alloy is supported by a non-etchable substrate which is a textile.

**29.** A process according to any one of the preceding claims wherein the metal or alloy is selected from the group consisting of bronze, beryllium, chromium, columbium, constantan, lead, magnesium, molybdenum, niobium, platinum, silver, titanium, tungsten, vanadiuim, zinc, zirconium, ferro metals and ferro alloys.

**Patentansprüche**

**1.** Verfahren zum Ätzen einer Metall- oder Legierungsoberfläche, umfassend das Aufbringen einer ätzbeständigen Tinte durch Tintenstrahldrucken auf ausgewählte Bereiche des Metalls oder der Legierung, das Exponieren der ätzbeständigen Tinte an eine aktinische Strahlung und/oder Teilchenstrahlbestrahlung zur Bewirkung einer Polymerisation, gegebenenfalls das Wärmebehandeln der ätzbeständigen Tinte und das anschließende Entfernen des exponierten Metalls oder der Legierung durch ein chemisches Ätzverfahren, wobei die ätzbeständige Tinte im Wesentlichen lösungsmittelfrei ist und die folgenden Komponenten umfasst:

A) 30 bis 90 Teile Acrylat-funktionelle Monomere;
B) 0 bis 50 Teile einer die Anhaftung an Metall fördernden organischen Verbindung;
C) 0 bis 20 Teile Polymer und/oder Präpolymer;
D) 0 bis 20 Teile Radikalinitiator;

E) 0 bis 5 Teile Färbemittel; und
F) 0 bis 5 Teile oberflächenaktives Mittel;

wobei die Tinte eine Viskosität von nicht höher als 200 cPs (mPa.s) bei 40°C besitzt, alle Teilangaben gewichtsbezogen sind und die Gesamtzahl der Teile

A) + B) + C) + D) + E) + F) = 100 ist, mit der Maßgabe, dass, wenn das Metall oder die Legierung von einem nicht-ätzbaren Substrat getragen wird, dieses keine Leiterplatte bildet; mit der Maßgabe, dass das Verfahren nicht ein Verfahren zur Herstellung einer elektronischen Vorrichtung ist, welche ein dielektrisches Substrat umfasst, das mit einem elektrisch leitenden Metall oder einer Legierung laminiert ist, wobei es das Aufbringen einer nichtwässrigen ätzbeständigen Tinte durch Tintenstrahldrucken auf ausgewählte Bereiche des Metalls oder der Legierung, das Exponieren der ätzbeständigen Tinte an eine aktinische Strahlung und/oder eine Teilchenstrahlbestrahlung zur Bewirkung einer Polymerisation, das Entfernen von exponiertem Metall oder Legierung durch ein chemisches Ätzverfahren und das anschließende Entfernen der polymerisierten ätzbeständigen Tinte durch Alkali umfasst, wobei die ätzbeständige Tinte im Wesentlichen lösungsmittelfrei ist und die folgenden Komponenten umfasst:
A) 30 bis 90 Teile Acrylat-funktionelle Monomere, die frei von Säuregruppen sind, umfassend eine Mono- oder höhere Funktionalität, wobei 5 - 95 Gew.-% ein oder mehrere monofunktionelle Monomere sind;
B) 1 bis 30 Teile Acrylat-funktionelles Monomer, enthaltend eine oder mehrere Säuregruppen;
C) 0 bis 20 Teile Polymer oder Präpolymer;
D) 0 bis 20 Teile Radikalinitiator;
E) 0 bis 5 Teile Färbemittel;
F) 0 bis 5 Teile oberflächenaktives Mittel; und

wobei die Tinte eine Viskosität von nicht höher als 30 cPs (mPa.s) bei 40°C besitzt und alle Teilangaben gewichtsbezogen sind.

2. Verfahren gemäß Anspruch 1, wobei die ätzbeständige Tinte 0,1 bis 50 Teile von Komponente B) auf Gewichtsbasis umfasst.

3. Verfahren gemäß Anspruch 1, wobei die ätzbeständige Tinte 0 bis 30 Teile von Komponente B) auf Gewichtsbasis umfasst.

4. Verfahren gemäß Anspruch 1, wobei die ätzbeständige Tinte 0,1 bis 30 Teile von Komponente B) auf Gewichtsbasis umfasst.

5. Verfahren gemäß einem beliebigen der Ansprüche 1 bis 4, wobei die ätzbeständige Tinte nicht-wässrig ist.

6. Verfahren gemäß einem beliebigen der Ansprüche 1 bis 5, wobei die Komponente A) 5 bis 95 Gew.-% von einem oder mehreren monofunktionellen Acrylatmonomeren umfasst, bezogen auf das Gesamtgewicht der Komponente A).

7. Verfahren gemäß einem der vorhergehenden Ansprüche,
wobei die ätzbeständige Tinte eine Viskosität von nicht höher als 30 cPs (mPa.s) bei 40°C besitzt.

8. Verfahren gemäß einem beliebigen der Ansprüche 1 bis 7, wobei die Metall- oder Legierungsoberfläche nicht von einem nicht-ätzbaren Substrat getragen wird oder bei dem das Metall oder die Legierung so getragen wird, dass dass das nicht-ätzbare Substrat nach dem Ätzverfahren entfernt wird.

9. Verfahren gemäß einem beliebigen der Ansprüche 1 bis 8, wobei die Komponente A) 70 bis 95 Gew.-% von einem oder mehreren monofunktionellen Acrylatmonomeren umfasst, bezogen auf das Gesamtgewicht der Komponente A).

10. Verfahren gemäß einem der vorhergehenden Ansprüche,
wobei alle Acrylat-funktionellen Monomere der Komponente A) gewichtsmittlere Molekulargewichte von nicht höher als 2000 besitzen.

11. Verfahren gemäß einem der vorhergehenden Ansprüche, wobei die Komponente A) mindestens ein Monomer umfasst, das aus Isobornylacrylat, Tripropylenglykoldiacrylat und Trimethylolpropanethoxylattriacrylat gewählt ist.

12. Verfahren gemäß einem der vorhergehenden Ansprüche, wobei die Komponente A) ein Acrylat-funktionelles Urethanoligomer umfasst.

13. Verfahren gemäß einem der vorhergehenden Ansprüche, wobei die die Anhaftung an Metall verbessernde organische Verbindung ein Acrylat-funktionelles Monomer ist.

14. Verfahren gemäß einem der vorhergehenden Ansprüche, wobei die die Anhaftung an Metall verbessernde organische Verbindung eine Metallchelatisierungsgruppe aufweist, welche eine Carbonsäure ist.

15. Verfahren gemäß Anspruch 14, wobei die die Anhaftung an Metall verbessernde organische Verbindung Methacrylsäure, Acrylsäure oder Mono-2-(methacryloyl)ethylphthalat ist oder diese umfasst.

16. Verfahren gemäß einem der vorhergehenden Ansprüche, wobei die Menge der die Anhaftung an Metall fördernden organischen Verbindung nicht größer als 10 Gewichtsteile ist.

17. Verfahren gemäß einem der vorhergehenden Ansprüche, wobei der Radikalinitiator ein durch UV-Licht aktivierter Photoinitiator ist.

18. Verfahren gemäß einem der vorhergehenden Ansprüche, wobei das oberflächenaktives Mittel eine oberflächenaktive Substanz von organischem Silikonacrylat ist.

19. Verfahren gemäß einem der vorhergehenden Ansprüche, wobei die ätzbeständige Tinte eine Oberflächenspannung von 20 bis 40 mN/m aufweist.

20. Verfahren gemäß einem der vorhergehenden Ansprüche, wobei die Viskosität der ätzbeständigen Tinte 8 bis 15 cPs (mPa.s) bei 40°C besitzt.

21. Verfahren gemäß einem der vorhergehenden Ansprüche, wobei die Komponente B) eine Säurezahl von höher als 200 mg KOH/g besitzt.

22. Verfahren gemäß einem der vorhergehenden Ansprüche, wobei die ätzbeständige Tinte eine Säurezahl von höher als 30 mg KOH/g besitzt.

23. Verfahren gemäß einem der vorhergehenden Ansprüche, wobei die Zahl der Teile der Komponente C) null ist.

24. Verfahren gemäß einem der vorhergehenden Ansprüche, welches die bei einer Temperatur von 80°C bis 200°C durchgeführte Wärmebehandlung einschließt.

25. Verfahren gemäß einem der vorhergehenden Ansprüche, wobei das Ätzverfahren nicht über die gesamte Dicke des Metalls oder der Legierung erfolgt.

26. Verfahren gemäß einem der vorhergehenden Ansprüche, wobei die polymerisierte ätzbeständige Tinte, die auf ausgewählte Bereiche der Metall- oder Legierungsoberfläche aufgebracht wird, anschließend von dem Metall oder der Legierung entfernt wird.

27. Verfahren gemäß Anspruch 26, wobei die polymerisierte ätzbeständige Tinte von dem Metall oder der Legierung durch Behandlung unter Anwendung alkalischer Bedingungen entfernt wird.

28. Verfahren gemäß einem der vorhergehenden Ansprüche, wobei das Metall oder die Legierung von einem nicht-ätzbaren Substrat getragen wird, welches ein Textil ist.

29. Verfahren gemäß einem der vorhergehenden Ansprüche, wobei das Metall oder die Legierung aus der Gruppe gewählt wird, die aus Bronze, Beryllium, Chrom, Columbium, Konstantan, Blei, Magnesium, Molybdän, Niobium, Platin, Silber, Titan, Wolfram, Vanadium, Zink, Zirkonium, Ferrometallen und Ferrolegierungen besteht.

**Revendications**

1. Procédé pour graver une surface en métal ou en alliage qui comprend l'application d'une encre résistante à la gravure par impression par jet d'encre à des zones sélectionnées du métal ou de l'alliage, l'exposition de l'encre résistante à la gravure à un rayonnement actinique et/ou à un rayonnement d'un faisceau de particules pour effectuer la polymérisation, éventuellement le traitement thermique de l'encre résistante à la gravure et ensuite l'élimination du métal ou de l'alliage exposé par un procédé de gravure chimique dans lequel l'encre résistante à la gravure est essentiellement exempte de solvant et comprend les composants suivantes :

    A) 30 à 90 parties de monomères à fonction acrylate ;
    B) 0 à 50 parties d'un composé organique favorisant l'adhérence au métal ;
    C) 0 à 20 parties d'un polymère et/ou d'un prépolymère ;
    D) 0 à 20 parties d'un initiateur radicalaire ;
    E) 0 à 5 parties d'un colorant ; et
    F) 0 à 5 parties d'un agent tensioactif ;

dans lequel l'encre possède une viscosité qui n'excède pas 200 cPs (mPa.s) à 40°C, toutes les parties sont en poids et le nombre total de parties

A) + B) + C) + D) + E) + F) = 100, à condition que lorsque le métal ou l'alliage est supporté par un substrat qui ne peut être gravé, il ne constitue pas une carte de circuits imprimés ; à condition que le procédé ne soit pas un procédé pour fabriquer un dispositif électronique qui comprend un substrat diélectrique stratifié avec un métal ou un alliage électroconducteur qui comprend l'application d'une encre résistante à la gravure non aqueuse par impression par jet d'encre sur des zones sélectionnées du métal ou de l'alliage, l'exposition de l'encre résistante à la gravure à un rayonnement actinique et/ou à un rayonnement d'un faisceau de particules pour effectuer la polymérisation, l'élimination du métal ou de l'alliage exposé par un procédé de gravure chimique et ensuite l'élimination de l'encre résistante à la gravure polymérisée par un alcali, dans lequel l'encre résistante à la gravure est essentiellement exempte de solvant et comprend les composants suivants :
A) 30 à 90 parties de monomères à fonction acrylate exempts de groupes acides comprenant des fonctionnalités mono ou plus, dans lesquels une partie de 5 à 95 % en poids est constituée d'un ou plusieurs monomères monofonctionnels ;
B) 1 à 30 parties d'un monomère à fonction acrylate contenant un ou plusieurs groupes acides ;
C) 0 à 20 parties d'un polymère ou d'un prépolymère ;
D) 0 à 20 parties d'un initiateur radicalaire ;
E) 0 à 5 parties d'un colorant ;
F) 0 à 5 parties d'un agent tensioactif ; et

dans lequel l'encre possède une viscosité qui n'excède pas 30 cPs (mPa.s) à 40°C et toutes les parties sont en poids.

2. Procédé selon la revendication 1, dans lequel l'encre résistante à la gravure comprend de 0,1 à 50 parties du composant B) en poids.

3. Procédé selon la revendication 1, dans lequel l'encre résistante à la gravure comprend de 0 à 30 parties du composant B) en poids.

4. Procédé selon la revendication 1, dans lequel l'encre résistante à la gravure comprend de 0,1 à 30 parties du composant B) en poids.

5. Procédé selon l'une quelconque des revendications 1 à 4, dans lequel l'encre résistante à la gravure est non aqueuse.

6. Procédé selon l'une quelconque des revendications 1 à 5, dans lequel le composant A) comprend de 5 à 95 % en poids d'un ou plusieurs monomères d'acrylate monofonctionnels, par rapport au poids total du composant A).

7. Procédé selon l'une quelconque des revendications précédentes, dans lequel l'encre résistante à la gravure possède une viscosité qui n'excède pas 30 cPs (mPa.s) à 40°C.

8. Procédé selon l'une quelconque des revendications 1 à 7, dans lequel la surface du métal ou de l'alliage n'est pas supportée par un substrat qui ne peut être gravé ou, lorsque le métal ou l'alliage est ainsi supporté, le substrat qui ne peut être gravé est éliminé par le procédé de gravure.

9. Procédé selon l'une quelconque des revendications 1 à 8, dans lequel le composant A) comprend de 70 à 95 % en poids d'un ou plusieurs monomères d'acrylate monofonctionnels, par rapport au poids total du composant A).

10. Procédé selon l'une quelconque des revendications précédentes, dans lequel tous les monomères à fonction acrylate du composant A) possèdent des masses moléculaires moyennes en poids qui n'excèdent pas 2 000.

11. Procédé selon l'une quelconque des revendications précédentes, dans lequel le composant A) comprend au moins un monomère choisi parmi l'acrylate d'isobornyle, le diacrylate de tripropylèneglycol et l'éthoxylate-triacrylate de triméthylolpropane.

12. Procédé selon l'une quelconque des revendications précédentes, dans lequel le composant A) comprend un oligomère d'uréthane à fonction acrylate.

13. Procédé selon l'une quelconque des revendications précédentes, dans lequel le composé organique favorisant l'adhérence au métal est un monomère à fonction acrylate.

14. Procédé selon l'une quelconque des revendications précédentes, dans lequel le composé organique favorisant l'adhérence au métal possède un groupe chélateur qui est un acide carboxylique.

15. Procédé selon la revendication 14, dans lequel le composé organique favorisant l'adhérence au métal est ou comprend de l'acide méthacrylique, de l'acide acrylique ou du phtalate de mono-2-(méthacryloyl)éthyle.

16. Procédé selon l'une quelconque des revendications précédentes, dans lequel la quantité de composé organique favorisant l'adhérence au métal n'excède pas 10 parties en poids.

17. Procédé selon l'une quelconque des revendications précédentes, dans lequel l'initiateur radicalaire est un photoinitiateur activé par rayonnement UV.

18. Procédé selon l'une quelconque des revendications précédentes, dans lequel l'agent tensioactif est un agent tensioactif organique d'acrylate-silicone.

19. Procédé selon l'une quelconque des revendications précédentes, dans lequel l'encre résistante à la gravure possède une tension superficielle de 20 à 40 mN/m.

20. Procédé selon l'une quelconque des revendications précédentes, dans lequel la viscosité de l'encre résistante à la gravure varie de 8 à 15 cPs (mPa.s) à 40°C.

21. Procédé selon l'une quelconque des revendications précédentes, dans lequel le composant B) possède un indice d'acide qui excède 200 mg de KOH/g.

22. Procédé selon l'une quelconque des revendications précédentes, dans lequel l'encre résistante à la gravure possède un indice d'acide qui excède 30 mg de KOH/g.

23. Procédé selon l'une quelconque des revendications précédentes, dans lequel le nombre de parties du composant C) est zéro.

24. Procédé selon l'une quelconque des revendications précédentes, lequel comprend le traitement thermique effectué à une température de 80°C à 200°C.

25. Procédé selon l'une quelconque des revendications précédentes, dans lequel le procédé de gravure ne s'effectue pas au travers de toute l'épaisseur du métal ou de l'alliage.

26. Procédé selon l'une quelconque des revendications précédentes, dans lequel l'encre résistante à la gravure polymérisée appliquée aux zones sélectionnées de la surface du métal ou de l'alliage est par la suite éliminée du métal ou de l'alliage.

**27.** Procédé selon la revendication 26, dans lequel l'encre résistante à la gravure polymérisée est éliminée du métal ou de l'alliage par traitement dans des conditions alcalines.

**28.** Procédé selon l'une quelconque des revendications précédentes, dans lequel le métal ou l'alliage est supporté par un substrat qui ne peut être gravé, lequel est un textile.

**29.** Procédé selon l'une quelconque des revendications précédentes, dans lequel le métal ou l'alliage est choisi parmi le groupe constitué du bronze, du béryllium, du chrome, du columbium, du constantan, du plomb, du magnésium, du molybdène, du niobium, du platine, de l'argent, du titane, du tungstène, du vanadium, du zinc, du zirconium, de ferro-métaux et de ferro-alliages.

## REFERENCES CITED IN THE DESCRIPTION

**Patent documents cited in the description**

- US 6197877 B
- GB 1508576 A
- GB 2108143 A
- WO 0114479 A

**Non-patent literature cited in the description**

- The Handbook of Chemistry and Physics. The Chemical Rubber Company, 1968-9